# EUROPÄISCHE PATENTSCHRIFT

(11) **EP 4 396 862 B1**
(45) Veröffentlichungstag und Bekanntmachung des Hinweises auf die Patenterteilung: **24.09.2025**
(21) Anmeldenummer: 22758478.6
(22) Anmeldetag: 29.07.2022
(51) Int. Cl.: H01L 21/48, H01L 23/373, H01L 23/473

(54) **ELEKTRONISCHES MODUL MIT WENIGSTENS EINEM LEISTUNGSHALBLEITER UND VERFAHREN ZU DESSEN HERSTELLUNG**
ELECTRONIC MODULE COMPRISING AT LEAST ONE POWER SEMICONDUCTOR AND METHOD FOR PRODUCING SAME
MODULE ÉLECTRONIQUE COMPRENANT AU MOINS UN SEMI-CONDUCTEUR DE PUISSANCE ET SON PROCÉDÉ DE PRODUCTION

(30) Priorität: 30.08.2021 DE 102021209482
(43) Veröffentlichungstag der Anmeldung: 10.07.2024
(73) Patentinhaber: Robert Bosch GmbH, 70442 Stuttgart (DE)
(72) Erfinder: KIEDROWSKI, Thomas, 74372 Sersheim (DE); WAYAND, Hartmut, 72793 Pfullingen (DE); MECKBACH, Johannes, 72070 Tuebingen (DE); LOEBER, Lukas, 71638 Ludwigsburg (DE); FISCHER, Arne Stephen, 70771 Leinfelden-Echterdingen (DE)
(86) Internationale Anmeldenummer: PCT/EP2022/071347
(87) Internationale Veröffentlichungsnummer: WO 2023/030789

(56) Entgegenhaltungen:
- EP-A1- 3 589 087
- WO-A1-2017/021394
- WO-A1-2018/055148
- WO-A2-2018/141621
- US-A1- 2019 206 629
- US-A1- 2020 279 791

## Beschreibung

### Technisches Gebiet

Die Erfindung betrifft ein elektronisches Modul mit wenigstens einem Leistungshalbleiter, der mittels eines Kühlelements gleichzeitig gekühlt und elektrisch kontaktiert werden kann. Ferner betrifft die Erfindung ein Verfahren zum Herstellen eines elektronischen Moduls.

### Stand der Technik

Aus der DE 10 2014 221 147 A1 der Anmelderin ist ein elektronisches Modul mit wenigstens einem Leistungshalbleiter mit den Merkmalen des Oberbegriffs des Anspruchs 1 bekannt. Das bekannte elektronische Modul weist auf gegenüberliegenden Seiten über einen mehrlagigen Schichtaufbau mit dem Leistungshalbleiter in Wirkverbindung angeordnete Kühlkörper auf, die eine Wärmeabfuhr von dem Leistungshalbleiter bewirken. Die als vorgefertigte Bauteile ausgebildeten, und ausschließlich zur Kühlung des Leistungshalbleiters dienenden Kühlelemente sind über Verbindungsschichten mit dem Leistungshalbleiter thermisch gekoppelt.

Die WO 2017/021394 A1 offenbart ein Bauteilmodul, wobei das Bauteilmodul ein Bauteil mit zumindest einem elektrischen Kontakt aufweist, bei welchem ein offenporiges Kontaktstück angebunden ist, wobei das Bauteilmodul ein Kühlsystem zur Kühlung mit einem Kühlfluid aufweist. Aus der WO 2018/055148 A1 ist ein Leistungsmodul bekannt, das mindestens einen Kühlkanal und mindestens ein Leistungsbauteil aufweist. Die EP 3 589 087 A1 offenbart einen Bauteilträger mit integrierten, wärmeleitenden Kühlstrukturen. Aus der WO 2018/141621 A2 ist ein Leistungsmodul bekannt. Die US 2020/279791 A1 offenbart ein Packverfahren und eine Verbindungstechnologie für ein elektronisches Gerät. Aus der US 2019/206629 A1 ist ein Verfahren zur Herstellung von elektronischen Komponenten durch 3D-Druck bekannt.

### Offenbarung der Erfindung

Das erfindungsgemäße elektronische Modul mit wenigstens einem Leistungshalbleiter mit den Merkmalen des Anspruchs 1 hat den Vorteil, dass es auf besonders vorteilhafte Art und Weise die Integration eines Kühlelements in einem mehrlagigen Schichtaufbau des Moduls ermöglicht, wobei das Kühlelement gleichzeitig der elektrischen Kontaktierung des Leistungshalbleiters mit einer Kontaktierungsanordnung dient. Über die Kontaktierungsanordnung erfolgt eine Ansteuerung bzw. eine Ankopplung des Leistungshalbleiters an eine Schaltung. Darüber hinaus ermöglicht es das elektronische Modul auf besonders einfache Art und Weise, für den jeweiligen Anwendungsfall optimierte Kühlelemente zur Verfügung zu stellen.

Der Erfindung liegt die Idee zugrunde, das Kühlelement durch ein generatives bzw. additives Herstellungsverfahren auszubilden, und zwar in einer Art und Weise, dass dieses als der elektrischen Kontaktierung dienendes Zwischenelement zwischen dem Leistungshalbleiter und der Kontaktierungsanordnung angeordnet ist.

Vor dem Hintergrund der obigen Erläuterungen wird es daher vorgeschlagen, ein erfindungsgemäßes elektronisches Modul mit wenigstens einem Leistungshalbleiter gemäß dem Anspruch 1 derart auszubilden, dass das wenigstens eine Kühlelement als ein in einem additiven Fertigungsverfahren hergestelltes Kühlelement ausgebildet ist, und dass das wenigstens eine Kühlelement zwischen dem wenigstens einen Leistungshalbleiter und der Kontaktierungsanordnung angeordnet ist und den wenigstens einen Leistungshalbleiter mit der Kontaktierungsanordnung elektrisch verbindet.

Vorteilhafte Weiterbildungen des erfindungsgemäßen elektronischen Moduls mit wenigstens einem Leistungshalbleiter sind in den Unteransprüchen aufgeführt.

Ein erfindungsgemäßes Modul sieht vor, dass das wenigstens eine Kühlelement aus mehreren Schichten aufgebaut ist, und dass die Schichten einen Kanal zur Führung eines Kühlmediums ausbilden. Eine derartige Ausgestaltung ermöglicht es somit insbesondere, einen geschlossenen Querschnitt zur Führung des Kühlmediums zur Verfügung zu stellen bzw. entsprechende Kanäle auszubilden. Dabei kommt als Kühlmedium insbesondere ein Gas, ersatzweise jedoch auch eine Kühlflüssigkeit infrage.

Eine weitere, besonders bevorzugte konstruktive Ausgestaltung zur Reduzierung thermomechanischer Spannungen bzw. Belastungen des Moduls im Bereich des Leistungshalbleiters sieht vor, dass das wenigstens eine Kühlelement in einer senkrecht zur Oberfläche des Leistungshalbleiters verlaufenden Richtung eine geringere Steifigkeit aufweist als in einer parallel zur Oberfläche des Leistungshalbleiters verlaufenden Richtung. Mit anderen Worten gesagt bedeutet dies, dass das Kühlelement in einer senkrecht zur Oberfläche des Leistungshalbleiters verlaufenden Richtung eine gewisse Flexibilität aufweist, um die erwähnten Spannungen senkrecht zur Oberfläche des Leistungshalbleiters zu kompensieren. Im Idealfall bildet das Kühlelement somit eine Art Federelement aus. Jedoch weist das Kühlelement auch in der anderen, parallel zur Ebene des Leistungshalbleiters verlaufenden Richtung eine gewisse Elastizität bzw. Federwirkung auf, um in dieser Richtung verlaufende mechanische Spannungen auszugleichen. Letztendlich erfolgt die Ausbildung der Geometrie des Kühlelements bzw. dessen Steifigkeit an den jeweiligen Anwendungsfall bzw. die Steifigkeit kann richtungsabhängig optimiert werden.

Eine erfindungsgemäße Ausbildung des Kühlelements sieht vor, dass das wenigstens eine Kühlelement auf gegenüberliegenden Seiten jeweils vollflächig ausgebildete erste und dritte Schichten aufweist, die mit dem Leistungshalbleiter bzw. der Kontaktierungsanordnung elektrisch verbunden sind, und dass sich unmittelbar an die vollflächig ausgebildeten ersten und dritten Schichten zweite Schichten anschließen, die den wenigstens einen Kanal zur Führung des Kühlmediums ausbilden.

Zur Optimierung der Kühlung bzw. um den Leistungshalbleiter von unterschiedlichen Seiten her elektrisch kontaktieren zu können, ist es darüber hinaus von besonderem Vorteil, wenn auf beiden gegenüberliegenden Seiten des wenigstens einen Leistungshalbleiters jeweils wenigstens ein Kühlelement angeordnet ist.

Zur Verbesserung der Anbindung bzw. der Sicherstellung der Verbindung zwischen dem Kühlelement und dem Leistungshalbleiter ist es vorgesehen, dass der wenigstens eine Leistungshalbleiter mittels einer Kontaktierungsschicht mit dem wenigstens einen Kühlelement verbunden ist, und dass das Material der Kontaktierungsschicht artgleich mit dem Material des Kühlkörpers ist. Die Artgleichheit des Materials des Kühlkörpers und der Kontaktierungsschicht, welche beispielsweise beide jeweils aus Aluminium oder Kupfer bestehen bzw. aufweisen können, ermöglicht insbesondere beim additiven Aufbau bzw. Aufschmelzen und anschließendem Erstarren des Materials des Kühlkörpers (für den Fall, dass der additive Aufbau über mehrere, aus metallischem Pulver bestehende und mittels eines Laserstahls aufgeschmolzene Schichten erfolgt), dass eine stoffschlüssige Verbindung zwischen der Kontaktierungsschicht und dem Material des Kühlkörpers ermöglicht wird.

Eine weitere bevorzugte Ausgestaltung des Moduls zur Optimierung der Kühlwirkung sieht vor, dass das wenigstens eine Kühlelement und der wenigstens eine Leistungshalbleiter innerhalb eines ein Kühlmedium aufnehmenden Gehäuses angeordnet sind, und dass die Kontaktierungsanordnung außerhalb des Gehäuses angeordnet ist und über im Gehäuse ausgebildete, vorzugsweise abgedichtete Öffnungen über ein Anschlusselement mit dem wenigstens einen Kühlelement verbunden ist.

In bevorzugter Weiterbildung dieses Vorschlags ist es vorgesehen, dass das Anschlusselement als monolithischer Bestandteil des Kühlelements ausgebildet ist. Das Anschlusselement, das somit Teil des Kühlelements ist bzw. zusammen mit dem Kühlelement im additiven Verfahren hergestellt wird, überbrückt somit den Bereich zwischen dem Kühlelement, der der eigentlichen Kühlung dient, und der Kontaktierungsanordnung.

Weiterhin betrifft die Erfindung ein Verfahren zum Herstellen eines elektronischen Moduls, das entsprechend der obigen Erläuterungen ausgebildet ist, wobei das erfindungsgemäße Verfahren zumindest folgende Schritte aufweist: Zunächst erfolgt ein Bereitstellen eines wenigstens eine Kontaktierungsschicht aufweisenden Leistungshalbleiters. Anschließend erfolgt das Ausbilden wenigstens eines Kühlelements in einem additiven Fertigungsverfahren auf der Oberfläche der wenigstens einen Kontaktierungsschicht. Zuletzt erfolgt ein zumindest mittelbares Verbinden des wenigstens einen Kühlelements auf der der Leistungshalbleiter abgewandten Seite mit einer Kontaktierungsanordnung.

In bevorzugter Weiterbildung dieses Verfahrens ist es vorgesehen, dass vor dem zumindest mittelbaren Verbinden des wenigstens einen Kühlelements mit der Kontaktierungsanordnung der wenigstens eine Leistungshalbleiter und das wenigstens eine Kühlelement innerhalb, und die Kontaktierungsanordnung außerhalb eines Gehäuses angeordnet werden.

Hinsichtlich der Ausbildung des Kühlelements ist es bevorzugt vorgesehen, dass das additive Ausbilden des wenigstens einen Kühlelements durch selektives Aufschmelzen und anschließendes Erstarren von Pulverschichten mittels eines Laserstrahls erfolgt, und dass die Einschweißtiefe und/oder der Energieeintrag des Laserstrahls beim Ausbilden der dem Leistungshalbleiter zugewandten unteren bzw. ersten Schichten des Kühlelements reduziert ist. Dadurch wird insbesondere eine thermische Überlastung bzw. Schädigung des Leistungshalbleiters vermieden. Die Reduktion der Einschweißtiefe ist dabei in gewissen Maßen durch eine Anpassung der Prozessparameter (z.B. Laserleistung, Laserverfahrgeschwindigkeit usw.) möglich. Alternativ bzw. zusätzlich ist es denkbar, das Aufschmelzen des Materials des Kühlkörpers unter Verwendung eines sogenannten Ultra-Kurz-Puls-Lasers zu verwenden. Die gepulste Laserstrahlung ermöglicht es, einerseits hohe absorbierte Intensitäten (notwendig zum Aufschmelzen des Ausgangswerkstoffs des Kühlkörpers) bei gleichzeitig vergleichsweise geringer absorbierter mittlerer Leistung (notwendig für den gewünschten geringen thermischen Eintrag in den Leistungshalbleiter) zu ermöglichen. Durch viele (im Bereich zwischen 1 MHz und 100 MHz) sehr schwache Pulse lässt sich eine sehr präzise und vor allem sehr geringe Einschweißtiefe erreichen. Auch ist eine Anpassung der Pulvergrößenverteilung zu kleineren Größen (zwischen 0,1µm und 5µm) notwendig, um diesen Prozess zu ermöglichen. Damit erreichen die dadurch erzielbaren Schichtdicken ebenfalls dieselbe Größenordnung, sodass eine relativ geringe Aufbaurate erzielbar ist. Sobald eine gewisse Aufbauhöhe (z.B. zwischen 10µm und 100µm) des Kühlkörpers erreicht ist, kann der Prozess auf das klassische Verfahren wechseln.

Eine weitere denkbare Anpassung des Herstellprozesses wäre die Verwendung des sogenannten LTM-Verfahrens (LTM = Laser-Transfer-Metallisierung), welches eine Weiterentwicklung des LIFT-Verfahrens (LIFT = Laser-Induced-Forward-Transfer) ist. Bei dem LTM-Verfahren wird eine Opferfolie, die aus dem aufzubauenden Material des Kühlelements besteht, oberhalb des Substrats bzw. Leistungshalbleiters aufgeschmolzen. Das aufgeschmolzene Material setzt sich auf dem Leistungshalbleiter nieder und bildet eine Grundschicht der aufzubauenden Strukturen des Kühlelements aus, auf die dann das Kühlelement im klassischen Pulverbettverfahren aufgebaut werden kann.

Alternativ kann es wiederum vorgesehen sein, die thermische Belastung des Leistungshalbleiters beim additiven Aufbau des Kühlelements dadurch zu reduzieren, dass die Kontaktierungsschicht am Leistungshalbleiter, auf der das Kühlelement aufgebaut wird, gegenüber dem Stand der Technik eine vergrößerte Dicke bzw. Höhe aufweist. Eine Steigerung um einige Mikrometer der Metallisierung gegenüber dem Stand der Technik hat bereits ein stark vergrößertes Prozessfenster für den additiven Prozess zur Folge. Dieses kann gegebenenfalls sogar so groß sein, dass auf die oben beschriebenen Maßnahmen zur Verringerung des Energieeintrags verzichtet werden kann. Auch ist es denkbar, durch Anpassungen des Werkstoffes der Metallisierung die thermische Belastung beim Schichtaufbau des Kühlelements zu reduzieren. Grundsätzlich sind auch Anpassungen des Substrats bzw. Leistungshalbleiters hinsichtlich des gesamten Schichtsystems der Metallisierung denkbar.

Vorzugsweise handelt es sich bei dem Pulver um ein metallisches Pulver. Das metallische Pulver besteht aus oder enthält Kupfer und/oder Aluminium und/oder eine Kupferlegierung und/oder eine Aluminiumlegierung. Alternativ oder zusätzlich enthält das metallische Pulver ein Komposit umfassend Kohlenstoff. In besonders vorteilhafter Weise ermöglicht der additive Aufbau ein Mischen der genannten Materialen zu einem Pulvergemisch, um so unterschiedliche Legierungen durch den Schmelzvorgang zu erzeugen.

Weitere Vorteile, Merkmale und Einzelheiten der Erfindung ergeben sich aus der nachfolgenden Beschreibung bevorzugter Ausführungsformen der Erfindung sowie anhand der Zeichnung.

### Kurze Beschreibung der Zeichnung

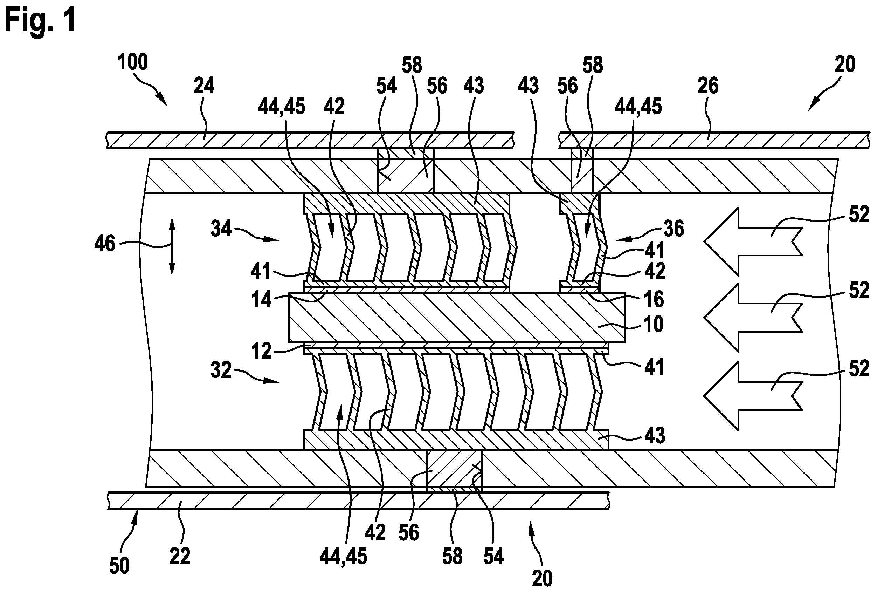

Die Fig. 1 zeigt in einem vereinfachten Längsschnitt ein elektronisches Modul mit einem Leistungshalbleiter unter Verwendung zweier, im additiven Fertigungsverfahren hergestellter Kühlelemente, die mit einer Kontaktierungsanordnung verbunden sind.

### Ausführungsformen der Erfindung

Das in der Fig. 1 dargestellte elektronische Modul 100 weist einen beim Betrieb wärmeerzeugenden Leistungshalbleiter 10 auf, der insbesondere in üblicher Art und Weise als Substrat ausgebildet ist. Auf den beiden gegenüberliegenden Oberflächen des Leistungshalbleiters 10 sind Kontaktierungsschichten 12, 14 und 16 in Form von Kontaktpads, aus Metall bestehend, vorgesehen, die in üblicher Art und Weise beispielsweise durch Aufdrucken aus Kupfer oder Aluminium ausgebildet sind. Die Kontaktierungsschichten 12, 14, 16 dienen der elektrischen Kontaktierung des Leistungshalbleiters 10 mit einer Leiterbahnen, Stanzgitter o.ä. Elemente aufweisenden Kontaktierungsanordnung 20, wobei die Kontaktierungsanordnung 20 für jeden der Kontaktierungsbereiche 12, 14 und 16 jeweils ein Anschlusselement 22, 24, 26 aufweist.

Die Verbindung zwischen den Kontaktierungsbereichen 12, 14, 16 und den Anschlusselementen 22, 24, 26 der Kontaktierungsanordnung 20 erfolgt über beispielhaft drei Kühlelemente 32, 34, 36, die jeweils im additiven Fertigungsverfahren hergestellt sind.

Die Kühlelemente 32, 34, 36 weisen jeweils wenigstens eine, typischerweise mehrere erste Schichten 41 auf, die in vollflächiger Überdeckung mit den Kontaktierungsschichten 12, 14, 16 angeordnet und mit diesen verbunden sind. Es folgen eine Vielzahl zweiter Schichten 42, die entsprechend der Fig. 1 dargestellt, die rein beispielhaft in Art eines Fischgrätmusters Hohlräume 44 als Bestandteil von Kanälen 45 ausbilden. Wesentlich dabei ist darüber hinaus, dass die zweiten Schichten 42 derart angeordnet bzw. ausgebildet sind, dass beispielhaft in einer senkrecht zur Ebene der Oberflächen des Leistungshalbleiters 10 verlaufenden Richtung entsprechend des Doppelpfeils 46 das Kühlelement 32, 34, 36 eine höhere Elastizität bzw. eine geringere Steifigkeit aufweist als in einer parallel zur Oberfläche des Leistungshalbleiters 10 verlaufenden Richtung. Jedoch weisen die Kühlelemente 32, 34 und 36 auch in einer parallel zur Ebene der Oberflächen des Leistungshalbleiters 10 verlaufenden Richtung eine Steifigkeit auf, die geringer ist als die eines aus Vollmaterial (d.h. ohne Hohlräume 44) ausgebildeten Kühlelements 32, 34, 36. Die zweiten Schichten 42 haben somit eine Doppelfunktion: Zum einen ermöglichen sie eine richtungsabhängige Anpassung der Steifigkeit bzw. Elastizität des Kühlelements 32, 34, 36 an den jeweiligen Anwendungsfall und zum anderen sind sie Bestandteil der Kühlung, an denen durch Umströmung eines Kühlmediums ein besonders guter Wärmeübergang infolge der Oberflächenvergrößerung durch die Hohlräume 44 sattfinden kann, sodass auf die Ausbildung separater Kühlkanäle verzichtet werden kann.

An die zweiten Schichten 42 schließen sich mehrere dritte Schichten 43 an, welche als vollflächig (d.h. ohne Lücken) ausgebildete Schichten beispielsweise in Überdeckung mit den ersten Schichten 41 angeordnet sind bzw. deren Fläche aufweisen.

Die soweit beschriebenen Kühlelemente 32, 34 und 36 sind zusammen mit dem Leistungshalbleiter 10 innerhalb eines Gehäuses 50 angeordnet. Das vorzugsweise geschlossen ausgebildete Gehäuse 50 ist mit einem der Kühlung dienenden Medium, welches als flüssiges Medium oder aber als gasförmiges Medium vorgesehen sein kann, befüllt. Vorzugsweise findet eine Durchströmung oder Zirkulation des Mediums entsprechend der Strömungspfeile 52 statt, und zwar derart, dass die Kühlelemente 32, 34 und 36 im Bereich der Querschnitte der Kanäle 45 von dem Medium durchströmt werden.

Das Gehäuse 50 weist dem jeweiligen Kühlelement 32, 34, 36 zugeordnet jeweils eine Durchgangsöffnung 54 auf, das von einem Anschlusselement 56 durchsetzt ist. Das Anschlusselement 56 ist monolithischer Bestandteil des Kühlelements 32, 34 und 36, d.h., dass das Kühlelement 32, 34, 36 zusammen mit dem jeweiligen Anschlusselement 56 in einem einzigen Fertigungsprozess hergestellt wird.

Außerhalb des Gehäuses 50 sind die Anschlusselemente 56 über weitere, insbesondere aus artgleichem Material wie die Kühlelemente 32, 34, 36 ausgebildete weitere Kontaktierungsschichten 58 mit den Anschlusselementen 22, 24, 26 verbunden.

## Patentansprüche

1. Elektronisches Modul (100) mit wenigstens einem Leistungshalbleiter (10), der mit einer Kontaktierungsanordnung (20) elektrisch verbunden ist, und mit wenigstens einem Kühlelement (32, 34, 36) zur zumindest mittelbaren Kühlung des wenigstens einen Leistungshalbleiters (10), wobei das wenigstens eine Kühlelement (32, 34, 36) als ein in einem additiven Fertigungsverfahren hergestelltes Kühlelement (32, 34, 36) ausgebildet ist, und dass das wenigstens eine Kühlelement (32, 34, 36) zwischen dem wenigstens einen Leistungshalbleiter (10) und der Kontaktierungsanordnung (20) angeordnet ist und den wenigstens einen Leistungshalbleiter (10) mit der Kontaktierungsanordnung (20) elektrisch verbindet,
**dadurch gekennzeichnet,**
**dass** das wenigstens eine Kühlelement (32, 34, 36) auf gegenüberliegenden Seiten jeweils vollflächig ausgebildete erste und dritte Schichten (41, 43) aufweist, die mit dem Leistungshalbleiter (10) bzw. der Kontaktierungsanordnung (20) elektrisch verbunden sind, und dass sich unmittelbar an die vollflächig ausgebildeten ersten und dritten Schichten (41, 43) zweite Schichten (42) anschließen, die wenigstens einen Kanal (45) zur Führung des Kühlmediums ausbilden.

2. Modul nach Anspruch 1,
**dadurch gekennzeichnet,**
**dass** das wenigstens eine Kühlelement (32, 34, 36) in einer senkrecht zur Oberfläche des Leistungshalbleiters (10) verlaufenden Richtung eine geringere Steifigkeit aufweist als in einer parallel zur Oberfläche des Leistungshalbleiters (10) verlaufenden Richtung.

3. Modul nach einem der Ansprüche 1 oder 2,
**dadurch gekennzeichnet,**
**dass** auf beiden gegenüberliegenden Seiten des wenigstens einen Leistungshalbleiters (10) jeweils wenigstens ein Kühlelement (32, 34, 36) angeordnet ist.

4. Modul nach einem der Ansprüche 1 bis 3,
**dadurch gekennzeichnet,**
**dass** der wenigstens eine Leistungshalbleiter (10) mittels einer Kontaktierungsschicht (12, 14, 16) mit dem wenigstens einen Kühlelement (32, 34, 36) verbunden ist, und dass das Material der Kontaktierungsschicht (12, 14, 16) artgleich mit dem Material des wenigstens einen Kühlelements (32, 34, 36) ist.

5. Modul nach einem der Ansprüche 1 bis 4,
**dadurch gekennzeichnet,**
**dass** das wenigstens eine Kühlelement (32, 34, 36) und der wenigstens eine Leistungshalbleiter (10) innerhalb eines ein Kühlmedium aufnehmenden Gehäuses (50) angeordnet sind, und/oder dass die Kontaktierungsanordnung (20) außerhalb des Gehäuses (50) angeordnet ist und über im Gehäuse (50) ausgebildete Öffnungen (54) über ein Anschlusselement (56) mit dem wenigstens einen Kühlelement (32, 34, 36) verbunden ist.

6. Modul nach Anspruch 5,
**dadurch gekennzeichnet,**
**dass** das Anschlusselement (56) als monolithischer Bestandteil des Kühlelements (32, 34, 36) ausgebildet ist.

7. Verfahren zum Herstellen eines elektronischen Moduls (100), das nach einem der Ansprüche 1 bis 6 ausgebildet ist, umfassend zumindest folgende Schritte:
- Bereitstellen eines wenigstens eine Kontaktierungsschicht (12, 14, 16) aufweisenden Leistungshalbleiters (10)
- Ausbilden wenigstens eines Kühlelements (32, 34, 36) in einem additiven Fertigungsverfahren auf der Oberfläche der wenigstens einen Kontaktierungsschicht (12, 14, 16)
- zumindest mittelbares Verbinden des wenigstens einen Kühlelements (32, 34, 36) auf der dem Leistungshalbleiter (10) abgewandten Seite mit einer Kontaktierungsanordnung (20).

8. Verfahren nach Anspruch 7,
**dadurch gekennzeichnet,**
**dass** vor dem zumindest mittelbaren Verbinden des wenigstens einen Kühlelements (32, 34, 36) mit der Kontaktierungsanordnung (20) der wenigstens eine Leistungshalbleiter (10), und das wenigstens eine Kühlelement (32, 34, 36) innerhalb und die Kontaktierungsanordnung (20) außerhalb eines Gehäuse (50) angeordnet werden.

9. Verfahren nach Anspruch 7 oder 8,
**dadurch gekennzeichnet,**
**dass** das additive Ausbilden des wenigstens einen Kühlelements (32, 34, 36) durch selektives Aufschmelzen und anschließendes Erstarren von Pulverschichten mittels eines Laserstrahls erfolgt, und dass die Einschweißtiefe und/oder der Energieeintrag des Laserstrahls beim Ausbilden der unteren Schichten des wenigstens einen Kühlelements (32, 34, 36) reduziert ist.

## Claims

1. Electronic module (100) having at least one power semiconductor (10) which is electrically connected to a contacting arrangement (20) and having at least one cooling element (32, 34, 36) for at least indirectly cooling the at least one power semiconductor (10),
wherein the at least one cooling element (32, 34, 36) is formed as a cooling element (32, 34, 36) produced in an additive manufacturing process, and in that the at least one cooling element (32, 34, 36) is arranged between the at least one power semiconductor (10) and the contacting arrangement (20) and electrically connects the at least one power semiconductor (10) to the contacting arrangement (20),
**characterized**
**in that**, on opposite sides, the at least one cooling element (32, 34, 36) respectively has full-area first and third layers (41, 43) which are electrically connected to the power semiconductor (10) or the contacting arrangement (20), and in that second layers (42) directly adjoin the full-area first and third layers (41, 43) and form at least one channel (45) for guiding the cooling medium.

2. Module according to Claim 1,
**characterized**
**in that** the at least one cooling element (32, 34, 36) has a lower stiffness in a direction running perpendicular to the surface of the power semiconductor (10) than in a direction running parallel to the surface of the power semiconductor (10).

3. Module according to either of Claims 1 and 2,
**characterized**
**in that** at least one respective cooling element (32, 34, 36) is arranged on each opposite side of the at least one power semiconductor (10).

4. Module according to one of Claims 1 to 3,
**characterized**
**in that** the at least one power semiconductor (10) is connected to the at least one cooling element (32, 34, 36) by means of a contacting layer (12, 14, 16), and in that the material of the contacting layer (12, 14, 16) is identical to the material of the at least one cooling element (32, 34, 36).

5. Module according to one of Claims 1 to 4,
**characterized**
**in that** the at least one cooling element (32, 34, 36) and the at least one power semiconductor (10) are arranged within a housing (50) that receives a cooling medium, and/or in that the contacting arrangement (20) is arranged outside the housing (50) and is connected via openings (54) formed in the housing (50) to at least one cooling element (32, 34, 36) by means of a connecting element (56).

6. Module according to Claim 5,
**characterized**
**in that** the connecting element (56) is formed as a monolithic component of the cooling element (32, 34, 36).

7. Method for producing an electronic module (100) which is designed according to any of Claims 1 to 6, comprising at least the following steps:
- providing a power semiconductor (10) having at least one contacting layer (12, 14, 16),
- forming at least one cooling element (32, 34, 36) in an additive manufacturing process on the surface of the at least one contacting layer (12, 14, 16),
- at least indirectly connecting the at least one cooling element (32, 34, 36), on the side facing away from the power semiconductor (10), to a contacting arrangement (20).

8. Method according to Claim 7,
**characterized**
**in that**, before the at least indirect connection of the at least one cooling element (32, 34, 36) to the contacting arrangement (20), the at least one power semiconductor (10) and the at least one cooling element (32, 34, 36) are arranged inside and the contacting arrangement (20) is arranged outside a housing (50).

9. Method according to Claim 7 or 8,
**characterized**
**in that** the at least one cooling element (32, 34, 36) is additively formed by selective melting and subsequent solidification of powder layers by means of a laser beam, and in that the welding depth and/or the energy input of the laser beam is reduced when forming the lower layers of at least one cooling element (32, 34, 36).

## Revendications

1. Module électronique (100) avec au moins un semi-conducteur de puissance (10), qui est raccordé électriquement à un ensemble de mise en contact (20), et avec au moins un élément de refroidissement (32, 34, 36) destiné à refroidir au moins indirectement l'au moins un conducteur de puissance (10),
l'au moins un élément de refroidissement (32, 34, 36) étant réalisé comme un élément de refroidissement (32, 34, 36) fabriqué lors d'un procédé de fabrication additive, et l'au moins un élément de refroidissement (32, 34, 36) étant disposé entre l'au moins un semi-conducteur de puissance (10) et l'ensemble de mise en contact (20) et raccordant électriquement l'au moins un semi-conducteur de puissance (10) à l'ensemble de mise en contact (20),
**caractérisé en ce**
**que** l'au moins un élément de refroidissement (32, 34, 36) comporte sur des côtés opposés des premières et troisièmes couches (41, 43) réalisées respectivement sur la totalité de la surface, qui sont raccordées électriquement au semi-conducteur de puissance (10) ou à l'ensemble de mise en contact (20), et que des deuxièmes couches (42), qui forment au moins un canal (45) destiné à guider le milieu de refroidissement, se raccordent directement aux premières et troisièmes couches (41, 43) réalisées sur la totalité de la surface.

2. Module selon la revendication 1,
**caractérisé en ce**
**que** l'au moins un élément de refroidissement (32, 34, 36) présente, dans une direction s'étendant perpendiculairement à la surface du semi-conducteur de puissance (10), une rigidité inférieure à celle dans une direction s'étendant parallèlement à la surface du semi-conducteur de puissance (10).

3. Module selon l'une des revendications 1 ou 2,
**caractérisé en ce**
**que** respectivement au moins un élément de refroidissement (32, 34, 36) est disposé sur les deux côtés opposés de l'au moins un semi-conducteur de puissance (10).

4. Module selon l'une des revendications 1 à 3,
**caractérisé en ce**
**que** l'au moins un semi-conducteur de puissance (10) est raccordé à l'au moins un élément de refroidissement (32, 34, 36) au moyen d'une couche de mise en contact (12, 14, 16), et que le matériau de la couche de mise en contact (12, 14, 16) est du même type que celui du matériau de l'au moins un élément de refroidissement (32, 34, 36).

5. Module selon l'une des revendications 1 à 4,
**caractérisé en ce**
**que** l'au moins un élément de refroidissement (32, 34, 36) et l'au moins un semi-conducteur de puissance (10) sont disposés à l'intérieur d'un boîtier (50) recevant un milieu de refroidissement et/ou que l'ensemble de mise en contact (20) est disposé à l'extérieur du boîtier (50) et est raccordé à l'au moins un élément de refroidissement (32, 34, 36) par un élément de connexion (56) par des ouvertures (54) réalisées dans le boîtier (50).

6. Module selon la revendication 5,
**caractérisé en ce**
**que** l'élément de connexion (56) est réalisé comme un élément monolithique de l'élément de refroidissement (32, 34, 36).

7. Procédé de fabrication d'un module électronique (100) qui est réalisé selon l'une des revendications 1 à 6, comprenant au moins des étapes suivantes :
- fourniture d'un semi-conducteur de puissance (10) comportant au moins une couche de mise en contact (12, 14, 16)
- réalisation d'au moins un élément de refroidissement (32, 34, 36) dans un procédé de fabrication additive sur la surface de l'au moins une couche de mise en contact (12, 14, 16)
- raccordement au moins indirect de l'au moins un élément de refroidissement (32, 34, 36) sur le côté, opposé au semi-conducteur de puissance (10), à un ensemble de mise en contact (20).

8. Procédé selon la revendication 7,
**caractérisé en ce**
**qu'**avant l'au moins un raccordement indirect de l'au moins un élément de refroidissement (32, 34, 36) à l'ensemble de mise en contact (20), l'au moins un semi-conducteur de puissance (10) et l'au moins un élément de refroidissement (32, 34, 36) sont disposés à l'intérieur d'un boîtier (50) et l'ensemble de mise en contact (20) est disposé à l'extérieur de celui-ci.

9. Procédé selon la revendication 7 ou 8,
**caractérisé en ce**
**que** la réalisation additive de l'au moins un élément de refroidissement (32, 34, 36) est effectuée par fusion sélective et par solidification consécutive de couches de poudre au moyen d'un rayon laser, et que la profondeur de soudage et/ou l'apport en énergie du rayon laser sont réduits lors de la réalisation des couches inférieures de l'au moins un élément de refroidissement (32, 34, 36).
